Europäisches Patentamt

European Patent Office

Office européen des brevets

(11) Veröffentlichungsnummer: **0 302 171 B1**

(19)

(12) **EUROPÄISCHE PATENTSCHRIFT**

(45) Veröffentlichungstag der Patentschrift: **09.09.92**

(51) Int. Cl.⁵: **G01R 21/00**

(21) Anmeldenummer: **88104145.3**

(22) Anmeldetag: **16.03.88**

(54) **Anordnung zur Umwandlung eines elektrischen Mehrphasensignals in eine Frequenz.**

(30) Priorität: **06.08.87 CH 3029/87**

(43) Veröffentlichungstag der Anmeldung:
**08.02.89 Patentblatt 89/06**

(45) Bekanntmachung des Hinweises auf die
Patenterteilung:
**09.09.92 Patentblatt 92/37**

(84) Benannte Vertragsstaaten:
**AT BE CH DE ES FR GB IT LI NL SE**

(56) Entgegenhaltungen:
**EP-A- 0 232 451**
**CH-A- 604 179**
**DE-A- 2 642 397**
**DE-A- 2 951 627**
**DE-B- 2 632 191**

(73) Patentinhaber: **Landis & Gyr Betriebs AG**

**CH-6301 Zug(CH)**

(72) Erfinder: **Renggli, Franz**
**Fluhmattstrasse 8a**
**CH-6033 Buchrain(CH)**
Erfinder: **Joder, Andreas**
**Binzenmatt 7**
**CH-6314 Unterägeri(CH)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf eine Anordnung zur Umwandlung einer Summe mehrerer, jeweils zu einem Einphasensignal eines Mehrphasensignals gehörender elektrischer Signale in eine proportionale Frequenz gemäss dem jeweiligen Oberbegriff der Ansprüche 1 bis 3.

Derartige Anordnungen dienen zu Messzwecken und werden, z. B. in Mehrphasen-Elektrizitätszählern, verwendet zur genauen Umwandlung einer Leistung eines Mehrphasensignals in eine Frequenz, die proportional der Summe der Leistungen von Einphasensignalen ist, die zusammen das Mehrphasensignal bilden.

Die zu den Einphasensignalen des Mehrphasensignals gehörenden elektrischen Signale, deren Summe in eine porportionale Frequenz umgewandelt wird, sind entweder Messsignale oder von Messsignalen abgeleitete Signale. Im ersteren Fall entsprechen die Messsignale z. B. gemessenen Leistungen und im letzteren Fall z. B. gemessenen elektrischen Spannungen und Strömen, deren Produkt elektrischen Leistungen entspricht.

Eine Anordnung der eingangs genannten Art ist aus der Druckschrift DE-A-29 51 627 bekannt, die für einen Dreiphasen-Elektrizitätszähler eine relativ aufwendige Korrekturschaltung zur Annullierung des Einflusses von Offsetspannungen und Driften beschreibt, welche zwei gleichaufgebaute Signalverarbeitungs-Schaltungen enthält, die je einen Multiplizierer pro Phase, eine Verdrahtung zum Summieren der Ausgangsignale der Multiplizierer, einen Analogfrequenzwandler und ein Kontrollglied enthalten. Ausserdem sind vorhanden:Ein erster und zweiter Messwertwandler pro Phase, ein zweipoliger erster Umschalter pro Phase, ein zweipoliger zweiter Umschalter, eine Teilerstufe, eine Zählstufe, ein einpoliger dritter Umschalter, ein Generator und eine Referenzsignal-Quelle. Die beiden Signalverarbeitungs-Schaltungen werden mittels der Umschalter, die im Betrieb periodisch und synchron umgeschaltet werden, abwechselnd in Betrieb genommen, d. h. ihre Eingange werden jeweils mit den Ausgängen der ersten Messwertwandler und ihr Ausgang wird jeweils über die Teilerstufe mit dem Eingang der Zählstufe verbunden. Die gerade nicht in Betrieb befindliche und an ihrem Ausgang sowie an ihren Eingängen abgetrennte Signalaufbereitungs-Schaltung läuft im Leerlauf mit, wobei dort jeweils der Analogfrequenzwandler und das Kontrollglied mittels des zweiten Umschalters zu einem Regelkreis zusammengeschaltet werden zwecks Erzeugung und Abspeicherung eines Korrekturwertes eines Messsignals.

Der Erfindung liegt die Aufgabe zugrunde, die aus der DE-A-29 51 627 bekannte Anordnung so zu verbessern, dass der dort grösstenteils benötigte doppelte Aufwand an Bauelementen vermieden werden kann.

Aus der Druckschrift DE-B-26 32 191 ist ein in einem Elektrizitätszähler verwendeter Strom/Frequenz-Wandler bekannt, der nach dem Ladungskompensationsprinzip arbeitet.

Ausserdem ist die Druckschrift US-A-41 24 821 bekannt, deren Gegenstand eine periodische Polaritätsumschaltung zur Eliminierung der Nullspannung ("Offset"-Spannung) eines in einem Miller-Integrator enthaltenen Oparationsverstärkers verwendet. Die Nullspannung wirkt sich in der Regel als nicht kompensierbarer zeit- und/oder temperaturabhängiger Anteil eines Eingangssignals direkt als Linearitätsfehler auf die Genauigkeit der Messung aus. Im Gegenstand der US-A-41 24 821 werden sowohl das zu wandelnde Signal als auch die Wirkung des letzteren in der Anordnung periodisch und gleichzeitig umgepolt, so dass die beiden Vorzeichenänderungen des zu wandelnden Signals sich gegenseitig aufheben. Die Nullspannung ihrerseits wird dagegen nicht periodisch umgepolt, sondern nur ihre Wirkung innerhalb der Anordnung. Dies hat zur Folge, dass innerhalb des Miller-Integrators die nicht periodisch umgepolte Nullspannung so wirksam ist, als ob sie total einmal periodisch umgepolt worden wäre. Eine Integration der Nullspannung über eine ganzzahlige Anzahl Perioden des Umschaltsignals ergibt dann den Wert Null, unter der Bedingung, dass beide Halbperioden des Umschaltsignals genau gleich lang andauern. Da im Augenblick der Polaritätsumschaltung in einem Integrationskondensator in der Regel noch eine von Null unterschiedliche Restladung vorhanden ist, wird diese nach der Polaritätsumschaltung mit falscher Polarität wirksam und führt zu einer Verfälschung des Messresultates. Ueber eine längere Messzeit betrachtet, braucht diese Verfälschung keinen negativen Einfluss auf den Mittelwert der Impulsfrequenz zu haben, sie führt aber in jedem Fall zu momentanen Schwankungen, d. h. zu einer Modulation der Impulsfrequenz. Um dies zu vermeiden, wird im Stand der Technik der Augenblick der Polaritätsumschaltung mit dem Ausgangssignal eines Komparators synchronisiert, der die Kondensatorspannung überwacht, so dass die Polartätsumschaltung immer im Nulldurchgang der Kondensatorspannung erfolgt, d. h. im Augenblick, wenn die Kondensator-Restladung Null ist. Diese Lösung führt jedoch dazu, dass die beiden Halbperioden des Umschaltsignals nicht immer genau gleich, sondern nur mehr im statistischen Mittel gleich lang andauern und so wieder zu einer unregelmässigen Modulation der Ausgangsfrequenz der Anordnung führen, was deren Eichung erschwert und erst nach einer untragbar langen Zeit ermöglicht.

Die Erfindung hat die Vorteile, dass sie für ein Mehrphasensignal verwendet werden kann, dass sowohl die Modulation der Ausgangsfrequenz der Anordnung durch ungleich lange Halbperioden des Umschaltsignals, als auch ihre Modulation durch Kondensator-Restladungen, die im Augenblick der Polaritätsumschaltung noch vorhanden sind, vermieden werden können und dass somit eine schnelle und präzise Eichung der Einrichtung ohne lange Wartezeiten möglich ist.

Die genannte Aufgabe wird erfindungsgemäss durch die im jeweiligen Kennzeichen der Ansprüche 1 bis 3 angegebenen Merkmale gelöst.

Ausführungsbeispiele der Erfindung sind in der Zeichnung dargestellt und werden im folgenden näher beschrieben.

Es zeigen:

Fig. 1 ein Blockschaltbild einer Anordnung für ein Einphasensignal,

Fig. 2 ein Blockschaltbild einer ersten Variante einer erfindungsgemässen Anordnung,

Fig. 3 ein Blockschaltbild einer zweiten Variante einer erfindungsgemässen Anordnung,

Fig. 4 ein Blockschaltbild einer dritten Variante einer erfindungsgemässen Anordnung,

Fig. 5 ein Schaltbild einer zur Fig. 2 gehörenden Summierschaltung und

Fig. 6 ein Schaltbild einer zu den Figuren 3 und 4 gehörenden Summierschaltung.

Gleiche Bezugszahlen bezeichnen in allen Figuren der Zeichnung gleiche Teile.

Alle Komponenten der beschriebenen Anordnungen sind z. B. in CMOS-Technologie aufgebaut und werden dann von einer positiven Speisegleichspannung $V_{DD}$ und einer negativen Speisegleichspannung $-V_{SS}$ gespeist, die beide die Masse als Bezugspotential besitzen. Die beiden Speisegleichspannungen werden, z. B. mit Hilfe eines Netzgleichrichters, auf an sich bekannte Weise von einer Netzwechselspannung $u_N$ abgeleitet. In der Zeichnung sind der Netzgleichrichter und seine Anschlüsse aus Gründen der besseren Uebersichtlichkeit nicht dargestellt.

In der Zeichnung sind alle fakultativ vorhandenen Verbindungen und Komponenten gestrichelt dargestellt. Takteingänge, die mit negativgehenden Flanken gesteuert werden, sind symbolisch mit einem schwarzen Dreieck versehen.

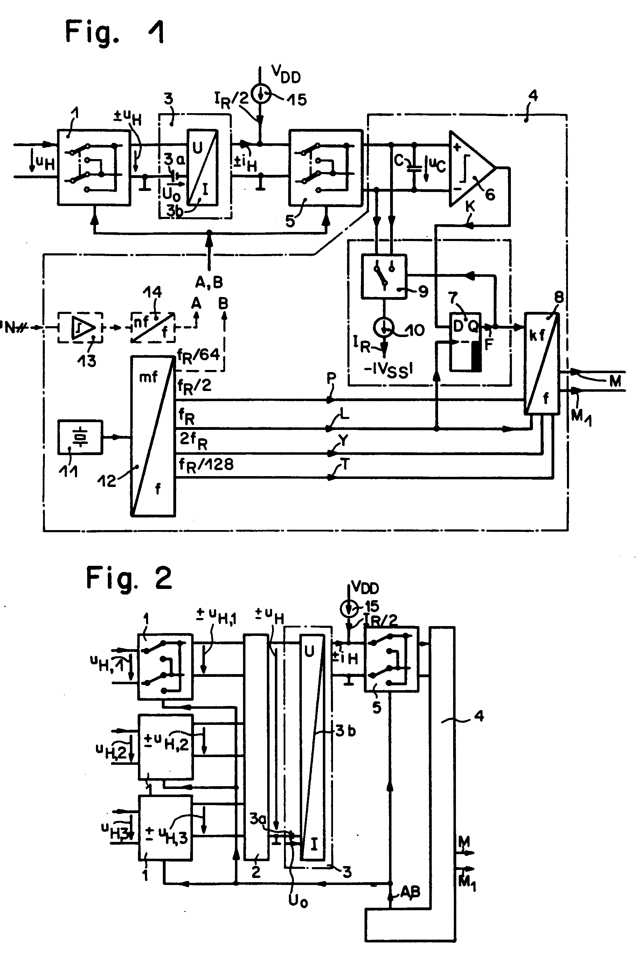

Die in der Fig. 1 dargestellte Anordnung besteht in der angegebenen Reihenfolge aus einer Kettenschaltung eines ersten Polwenders 1, eines Spannungs/Strom-Wandlers 3, eines zweiten Polwenders 5 und einer Schaltung 4. Die Schaltung 4 besteht ihrerseits aus einem Kondensator C, einem Komparator 6, einem D-Flip Flop 7, einem Ausgangsfrequenzteiler 8, einem Umschalter 9, einer Konstantstromquelle 10, einem Taktgenerator 11, einem Taktfrequenzteiler 12, einem fakultativ vorhandenen weiteren Komparator 13 und einem fakultativ vorhandenen Umschaltfrequenzteiler 14. Ferner ist noch eine weitere Konstantstromquelle 15 vorhanden als Signalquelle, deren erster Pol mit einem nicht an Masse liegenden Ausgangspol des Spannungs/Strom-Wandlers 3 verbunden ist, während ihr zweiter Pol an der positiven Speisegleichspannung $V_{DD}$ liegt. Die Eingänge und Ausgänge der beiden Polwender 1 und 5 sowie des Spannungs/Strom-Wandlers 3 sind alle zweipolig, wobei je ein Eingangspol des Spannungs/Strom-Wandlers 3 und des Polwenders 5 an Masse liegt. Innerhalb der Schaltung 4 ist deren zweipoliger Eingang auf den Kondensator C geführt, dessen erster Pol zusätzlich noch mit einem nichtinvertierenden Eingang des Komparators 6 und über einen Arbeitskontakt des Umschalters 9 mit einem ersten Pol der Konstantstromquelle 10 verbunden ist, während sein zweiter Pol zusätzlich noch auf einen invertierenden Eingang des Komparators 6 und über einen Ruhekontakt des Umschalters 9 auf den ersten Pol der Konstantstromquelle 10 geführt ist, deren zweiter Pol an der negativen Speisegleichspannung $-V_{SS}$ liegt. Der Ausgang des Komparators 6 ist mit einem D-Eingang des D-Flip Flops 7 verbunden, dessen Q-Ausgang einerseits auf einen Steuereingang des Umschalters 9 und andererseits auf einen ersten Signaleingang des Ausgangsfrequenzteilers 8 geführt ist.

Der Ausgang des Taktgenerators 11 ist mit einem Eingang des Taktfrequenzteilers 12 verbunden, der z. B. fünf Ausgänge besitzt. Sein erster Ausgang, an dem ein Taktsignal P der Frequenz $f_R/2$ ansteht, ist auf einen zweiten Signaleingang des Ausgangsfrequenzteilers 8 geführt, sein zweiter Ausgang, an dem ein Taktsignal L der Frequenz $f_R$ ansteht, ist mit einem Takteingang des D-Flip Flops 7 und mit einem ersten Takteingang des Ausgangsfrequenzteilers 8 verbunden, während sein dritter Ausgang, an dem ein Taktsignal T der Frequenz $f_R/128$ ansteht, auf einen zweiten Takteingang des Ausgangsfrequenzteilers 8 geführt ist. Sein vierter Ausgang, an dem ein Taktsignal Y der Frequenz $2f_R$ ansteht, ist mit einem dritten Takteingang des Ausgangsfrequenzteilers 8 verbunden.

Eine Wechselsteuerspannung $u_N$, z. B. eine 50 Hz- oder 60 Hz-Netzwechselspannung, speist fakultativ zweipolig den Eingang des Komparators 13, dessen Ausgang mit dem Eingang des Umschaltfrequenzteilers 14 verbunden ist. Miteinander verbundene Steuereingänge der beiden Polwender 1 und 5 werden entweder vom Ausgang des Umschaltfrequenzteilers 14 mit einem Umschaltsignal A oder vom fünften Ausgang des Taktfrequenzteilers 12 mit einem Umschaltsignal B über eine Drahtverbindung gespeist. Falls das Umschaltsignal B verwendet wird, können natürlich der Komparator 13 und der Umschaltfrequenzteiler 14 eingespart werden. Der Ausgangsfrequenzteiler 8 besitzt z. B. zwei Ausgänge, die gleichzeitig die Ausgänge der Schaltung 4 sind und an denen die zwei Signale M und $M_1$ anstehen. Das Signal M entspricht z. B. einen positiven Wert und das Signal $M_1$ einem negativen Wert des Signals $u_H$, welches am Eingang des ersten Polwenders 1 ansteht.

Die beiden Polwender 1 und 5 sind gleich aufgebaut und bestehen je aus einem zweipoligen Umschalter, der z. B. mit Hilfe bekannter Halbleiter-Analogschalter in CMOS-Technologie aufgebaut ist. Dabei ist innerhalb der Polwender 1 und 5 (siehe Symbole in den Blöcken 1 und 5 der Fig. 1) jeweils ein erster Eingangspol der Polwender 1 und 5 sowohl über einen ersten ihrer Ruhekontakte mit einem ersten ihrer Ausgangspole als auch über einen ersten ihrer Arbeitskontakte mit einem zweiten ihrer Ausgangspole verbunden, während ihr zweiter Eingangspol sowohl über einen zweiten ihrer Ruhekontakte mit dem zweiten ihrer Ausgangspole als auch über einen zweiten ihrer Arbeitskontakte mit dem ersten ihrer Ausgangspole verbunden ist. Der Umschalter 9 ist einpolig und z. B. auch mit Hilfe bekannter Halbleiter-Analogschalter in CMOS-Technologie aufgebaut.

Der Taktfrequenzteiler 12 und der Umschaltfrequenzteiler 14 sind z. B. mit Hilfe bekannter Binärzähler in CMOS-Technologie aufgebaut und ermöglichen eine synchrone Frequenzteilung durch eine Zahl $2^x$, wobei x ganzzahlig ist.

Der Taktgenerator 11 ist z. B. quarzstabilisiert und erzeugt rechteckförmige Taktimpulse, z. B. der Frequenz $2^{15}$ = 32,768 kHz. Diese Frequenz wird im nachgeschalteten Taktfrequenzteiler 12 z. B. durch m geteilt, wobei m die Werte $2^4$, $2^5$, $2^6$, $2^{11}$ und $2^{12}$ besitzt, zur Erzeugung der Frequenzen $2f_R$ = $2^{11}$ Hz des Taktsignals Y, $f_R$ = 210 Hz des Taktsignals L, $f_R/2$ = $2^9$ Hz des Taktsignals P, $f_R/64$ = $2^4$ Hz = 16 Hz des Umschaltsignals B und $f_R/128$ = $2^3$ Hz des Taktsignals T.

Die Wechselsteuerspannung $u_N$ wird im Komparator 13 in ein periodisches rechteckförmiges Impulssignal der gleichen Frequenz umgewandelt. Die Schaltschwelle des Komparators 13 ist vorzugsweise so gewählt, dass die Umschaltung im nachgeschalteten Umschaltfrequenzteiler 14 genau bei den Nulldurchgängen der Wechselsteuerspannung $u_N$ erfolgt. Im nachfolgenden Umschaltfrequenzteiler 14 wird dann die z. B. 50 Hz- bzw. 60 Hz-Frequenz dieses rechteckförmigen Impulssignals durch n geteilt, wobei n z. B. den Wert $2^2$ besitzt, zur Erzeugung einer Frequenz von 12,5 Hz bzw. 15 Hz des Umschaltsignals A. Die beiden Polwender 1 und 5 werden somit synchron und periodisch mit der Frequenz 12,5 Hz oder 15 Hz (Umschaltsignal A) bzw. mit der Frequenz 16 Hz (Umschaltsignal B) vom gleichen Umschaltsignal A bzw. B gesteuert und umgeschaltet. Der Komparator 13 und der Umschaltfrequenzteiler 14 bzw. der Taktgenerator 11 und teilweise der Taktfrequenzteiler 12 bilden somit zusammen eine Steuerschaltung zur Erzeugung des periodischen Umschaltsignals A bzw. B der beiden Polwender 1 und 5.

Der Spannungs/Strom-Wandler 3 besitzt in der Praxis eine unvermeidbare Nullspannung ("Offset"-Spannung) $U_o$, die in den Figuren 1 und 2 symbolisch dargestellt sind durch je eine Spannungsquelle 3a, die in Reihe geschaltet ist mit einem Eingangspol eines idealen, nullspannungslosen Spannungs/Strom-Wandlers 3b. Die Spannungsquelle 3a und der ideale, nullspannungslose Spannungs/Strom-Wandler 3b bilden zusammen den nichtidealen Spannungs/Strom-Wandler 3.

Das D-Flip Flop 7 wird z. B. mit negativgehenden Flanken gesteuert.

Ein zu wandelndes Signal $u_H$ wird in Gestalt einer elektrischen Spannung zweipolig dem Eingang des Polwenders 1 zugeführt. Im Falle eines Elektrizitätszählers ist $u_H$ proportional $u_N.i_L$ und wird z. B. mit Hilfe eines nicht dargestellten Hallelementes erzeugt, wobei $u_N$ die Netzspannung eines Energieversorgungsnetzes und $i_L$ ein Laststrom ist, dessen Magnetfeld von dem Hallelement gemessen wird, während der Speisestrom des Hallelementes von der Netzspannung $u_N$ proportional erzeugt wird. Der Polwender 1 polt das Signal $u_H$ periodisch um. Während z. B. allen ungeradzahligen Halbperioden des Umschaltsignals A bzw. B erscheint das Signal $+u_H$ am Ausgang des Polwenders 1 und während allen geradzahligen Halbperioden das Signal $-u_H$.

Das periodisch umgepolte Signal wird im nachgeschalteten Spannungs/Strom-Wandler 3 in einen proportionalen Signalstrom $(+/-)i_H$ umgewandelt. Nach dieser Spannungs/Strom-Wandlung und noch vor einer nachfolgenden Integration wird am Ausgang des Spannungs/Strom-Wandlers 3 ein Gleichstrom $I_R/2$ als konstantes Referenzsignal zum durch den Spannungs/Strom-Wandler 3 erzeugten Stromsignal $(+/-)i_H$ addiert zwecks Bildung eines Summensignals $(+/-)i_H + I_R/2$. Die Konstantstromquelle 15 erzeugt dabei den Gleichstrom $I_R/2$.

Der Polwender 5, der zwischen dem Spannungs/Strom-Wandler 3 und dem Kondensator C angeordnet ist, polt das Ausgangssignal des Spannungs/Strom-Wandlers 3 synchron zur periodischen Umpolung des Signals $u_H$ ebenfalls periodisch um, so dass der Kondensator C vom Polwender 5 her dauernd einen Strom $(+/-)I_R/2 + i_H$ geliefert bekommt. Das zweimal periodisch umgepolte, zu $u_H$ proportionale Signal $i_H$ wird schliesslich im Kondensator integriert.

Da der Spannungs/Strom-Wandler 3, wie bereits erwähnt, an seinem Eingang in der Regel eine

Nullspannung $U_o$ besitzt, der am Ausgang des Spannungs/Strom-Wandlers 3 ein proportionaler Strom $I_o$ entspricht, ist der Eingangsstrom des Polwenders 5 in Wirklichkeit nicht ideal gleich $(+/-)i_H + I_R/2$, sondern gleich $(+/-)i_H + I_R/2 + I_o$.

Der Wert des Referenzsignales $I_R/2$ muss die Bedingung $I_R/2 > |(+/-)i_H + I_o|$ erfüllen. Anders ausgedrückt: Der Wert des konstanten Referenzsignals $I_R/2$ ist grösser zu wählen als der um den Einfluss $I_o$ der Nullspannung erhöhte, am Ort der Addition vorhandene Wert der Amplitude $i_H$ desperiodisch umgepolten Signals $(+/-)i_H$.

Der Spannungs/Strom-Wandler 3 und der nachgeschaltete Kondensator C, in den erfindungsgemässen Anordnungen ergänzt durch eine Summierschaltung 2 oder 2a, bilden zusammen einen Integrator 3; C bzw. 2;3;C bzw. 2a;3,C. Der diesem Integrator 3; C nachgeschaltete Komparator 6 überwacht dessen Ausgangsspannung, nämlich die Kondensatorspannung $u_C$, zwecks Steuerung des Zu- und Abschaltens des von der Konstantstromquelle 10 gelieferten, konstanten Referenzstromes $I_R$ bei Ueber- bzw. Unterschreitung eines Schwellwertes unter gleichzeitiger Erzeugung rechteckförmiger Ausgangsimpulse. Für den Fall, dass das Signal $u_H$ konstant ist, hat die Kondensatorspannung $u_C$ einen sägezahnförmigen Verlauf, dessen positiv- und negativgehende Flanken alle jeweils unter sich parallel verlaufen.

Der vom D-Flip Flop 7 gesteuerte Umschalter 9 dient dem Zu- und Abschalten des Referenzstromes $I_R$. Wie bereits erwähnt, wird dem Kondensator C vom Polwender 5 her ein Strom $i_H + (+/-)I_R/2 + (+/-)I_o$ geliefert, wobei sich das Pluszeichen auf ungeradzahlige und das Minuszeichen auf geradzahlige Halbperioden des Umschaltsignals A bzw. B bezieht. Wenn zu Beginn das Ausgangssignal F des D-Flip Flops 7 einen Logikwert "0" besitzt, dann nimmt zu Anfang der Umschalter 9 die in der Fig. 1 dargestellte Position ein. Somit ist die Konstantstromquelle 10 während der ungeradzahligen Halbperioden des Umschaltsignals A bzw. B, während der der Polwender 5 ebenfalls die in der Fig. 1 dargestellte Position einnimmt, immer nur mit dessen momentan an Masse liegendem Anschluss verbunden. Der Referenzstrom $I_R$ der Konstantstromquelle 10 fliesst in die Masse und kann den Kondensator C nicht laden. Während einer jeden ungeradzahligen Halbwelle des Umschaltsignals A bzw. B wird somit der Kondensator C nur vom Polwender 5 her mit dem Strom $i_H + I_R/2 + I_o$ geladen. Dadurch steigt die vom Komparator 6 überwachte Spannung $u_C$ am Kondensator C an. Der Komparator 6 besitzt z. B. einen Eingangsschwellwert von 0 Volt. Ueberschreitet die Spannung am Kondensator C den Eingangsschwellwert des Komparators 6, dann ändert dessen Ausgangssignal K seinen Wert vom Logikwert "0" auf einen Logikwert "1". Die Zustandsänderung des Ausgangssignals K wird mit der nächsten negativgehenden Flanke des hochfrequenten Taktsignals L in das dem Komparator 6 nachgeschaltete D-Flip Flop 7 übernommen. Dieses dient dazu, das rechteckförmige Ausgangssignal K des Komparators 6 mit dem rechteckförmigen Taktsignal L, dessen Frequenz, wie bereits erwähnt, z. B. $2^{10}$ Hz beträgt, zu synchronisieren. Die Logikwertänderung des D-Flip Flops 7 steuert mit Hilfe von dessen Ausgangssignal F den Umschalter 9 und schaltet diesen um, so dass dieser jetzt die entgegengesetzte von der in der Fig. 1 dargestellten Position einnimmt. Dadurch wird jetzt zusätzlich der Referenzstrom $I_R$ der Konstantstromquelle 10 durch den Kondensator C fliessen.

Der Ladestrom des Kondensators C ist damit gleich:

$$i_H + I_R/2 + I_o - I_R = i_H - I_R/2 + I_o,$$

d. h. der Term $I_R/2$ hat sein Vorzeichen geändert. Da jedoch, wie bereits erwähnt, die Bedingung $I_R/2 > |i_H + I_o|$ gilt, ist der resultierende Ladestrom negativ.

Die Spannung am Kondensator C sinkt und, wenn sie den Eingangsschwellwert des Komparators 6 unterschreitet, nimmt dessen Ausgangssignal K wieder seinen ursprünglichen Logikwert "0" an. Auch diese Wertänderung wird wieder durch die nächste negativgehende Flanke des Taktsignals L in das D-Flip Flop 7 übernommen, was dazu führt, dass der Umschalter 9 wieder seine ursprüngliche Position einnimmt, so dass ein neuer Zyklus beginnen kann. Dies wiederholt sich so oft, bis dass die ungeradzahlige Halbperiode des Umschaltsignals A bzw. B beendet ist. Jedem Impuls des Ausgangssignals F entspricht dabei eine einzige, mit Hilfe des Referenzstromes $I_R$ durchgeführteEntladung des Kondensators C.

Am Ende einer jeden ungeradzahligen Halbperiode des Umschaltsignals A bzw. B werden die beiden Polwender 1 und 5 vom Umschaltsignal A bzw. B synchron umgeschaltet, so dass sie beide die entgegengesetzte von der in der Fig. 1 dargestellten Position einnehmen. Nach dem Umschalten des Polwenders 5 ist diesmal die Konstantstromquelle 10 bei der in der Fig. 1 dargestellten Position des Umschalters 9 mit den beiden Polen des Kondensators C verbunden und somit in Betrieb. Unter der Annahme, dass zu Beginn der nun beginnenden geradzahligen Halbperiode des Umschaltsignals A bzw. B der Umschalter 9 z. B. wieder die in der Fig. 1 dargestellte Position einnimmt, wird der Kondensator C sowohl vom Polwender 5 her mit dem Strom $i_H - I_R/2 - I_o$ als auch von der Konstantstromquelle 10 her mit dem Referenzstrom $I_R$ geladen. Der totale Ladestrom ist so-

mit: $i_H - I_R/2 - I_o + I_R =$
$i_H + I_R/2 - I_o$.

Die Spannung am Kondensator C steigt an und, wenn sie den Eingangsschwellwert des Komparators 6 überschreitet, ändert dessen Ausgangssignal K seinen Wert vom Logikwert "0" auf den Logikwert "1". Diese Wertänderung führt auf die bereits beschriebene Weise dazu, dass der Umschalter 9 umschaltet und dadurch die Konstantstromquelle 10 mit dem an Masse liegenden Anschluss des Kondensators C verbunden wird. Der Kondensator wird jetzt nur mehr vom Polwender 5 her mit dem Strom

$i_H - I_R/2 - I_o$

geladen, der negativ ist, da die Bedingung

$i_R/2 > |(+/-)i_H + I_o|$

gilt. Die Kondensatorspannung nimmt ab und, wenn sie den Eingangsschwellwert des Komparators 6 unterschreitet, ändert dessen Ausgangssignal seinen Wert zurück auf den Logikwert "0", wodurch der Umschalter 9 in seine Ausgangsposition zurückgeschaltet wird, so dass ein neuer Zyklus beginnen kann. Dies wiederholt sich so oft, bis dass die geradzahlige Halbperiode des Umschaltsignals A bzw. B beendet ist.

Zusammengefasst gilt: Während einer ungeradzahligen Halbperiode des Umschaltsignals A bzw. B wird der Kondensator C abwechslungsweise mit einem Strom $i_H + I_R/2 + I_o$ geladen und mit einem Strom $i_H - I_R/2 + I_o$ entladen. Während einer geradzahligen Halbperiode des Umschaltsignals A bzw. B wird der Kondensator C dagegen abwechslungsweise mit einem Strom $i_H + I_R/2 - I_o$ geladen und mit einem Strom $i_H - I_R/2 - I_o$ entladen. Beide Arten Halbperioden unterscheiden sich somit nur durch das Vorzeichen des Stromes $I_o$. Da die Umschaltsignale A und B durch die Art ihrer Erzeugung genau gleich lange Halbperioden besitzen und da das Vorzeichen des Stromes $I_o$ in zwei aufeinanderfolgenden Halbperioden unterschiedlich ist, eliminiert sich $I_o$ unddamit auch der Einfluss der Nullspannung $U_o$ bei einer Integration über eine ganzzahlige Anzahl Perioden des Umschaltsignals A bzw. B.

Die Ladung, die dem Kondensator C während einer jeden ungeradzahligen Halbperiode durch den Strom $i_H + I_R/2 + I_o$ vom Polwender 5 her dauernd zufliesst, wird ihm jeweils fortlaufend in kleinen, konstanten, genau definierten Ladungsmengen $Q_R = I_R/f_R$ durch das Zuschalten der Konstantstromquelle 10 entzogen unter gleichzeitiger Abgabe eines rechteckförmigen Impulses pro Quantum am Q-Ausgang des D-Flip Flops 7. Die Ladung, die dem Kondensator C während einer jeden geradzahligen Halbperiode durch den Strom $i_H - I_R/2 - I_o$ vom Polwender 5 her dauernd entzogen wird, wird ihm jeweils fortlaufend in kleinen, konstanten, genau definierten Ladungsmengen $Q_R$ durch das Zuschalten der Konstantstromquelle 10 wieder zugeführt, so dass der totale Ladestrom des Kondensators C dem Summenstrom

$(i_H - I_R/2 - I_o) + I_R = i_H + I_R/2 - I_o$

entspricht, wobei auch diesmal wieder gleichzeitig ein rechteckförmiger Impuls pro Quantum am Q-Ausgang des D-Flip Flops 7 abgegeben wird. Jeder dieser Impulse ist somit ein Mass für das kleine, genau definierte Ladungsquantum, das dem Kondensator C mit Hilfe des Referenzstromes $I_R$ entzogen bzw. zugeführt wird. Bedingt durch die Umpolung des Kodensators C ist die Polarität des Ladestromes $(+/-)I_o + i_H + I_R/2$ unverändert und somit wird die zur Zeit der periodischen Umpolung im Kondensator C noch anstehende Restladung in der nachfolgenden Halbperiode mit der richtigen Polarität berücksichtigt, so dass keine durch die Restladung bedingte Modulation der Ausgangsfrequenz entstehen kann.

Das mit Hilfe der Integration und des Komparators 6 erzeugte Ausgangsignal F des D-Flip Flops 7 besteht aus rechteckförmigen Impulsen. Die mittlere Frequenz $f_F$ dieser Impulse ist proportional dem Summenstrom $i_H + I_R/2$ unddamit um eine konstante Frequenz $f_R/2$ zu gross, wenn die Frequenz $f_R/2$ die Frequenz darstellt, die dem Wert des Referenzsignals $I_R/2$ entspricht. Die Frequenz $f_R/2$ ist auch die Frequenz der rechteckförmigen Impulse des Taktsignals P. Um eine Ausgangsfrequenz der Anordnung zu erhalten, die nur proportional dem Signalstrom $i_H$ und damit auch nur proportional dem Signal $u_H$ ist, muss somit noch von der Frequenz $f_F$ des Ausgangssignals F die konstante Referenzfrequenz $f_R/2$ des Taktsignals P subtrahiert werden. Dies geschieht mit Hilfe eines in der Gestalt des Ausgangsfrequenzteilers 8 am Ausgang der Anordnung vorhandenen Vorwärts/Rückwärts-Zählers, indem dort die Impulse des Ausgangssignals F des D-Flip Flops 7 vorwärts und diejenigen des Taktsignals P rückwärts gezählt werden. Gleichzeitig teilt der Ausgangsfrequenzteiler 8 noch diese Frequenzdifferenz durch eine Zahl k.

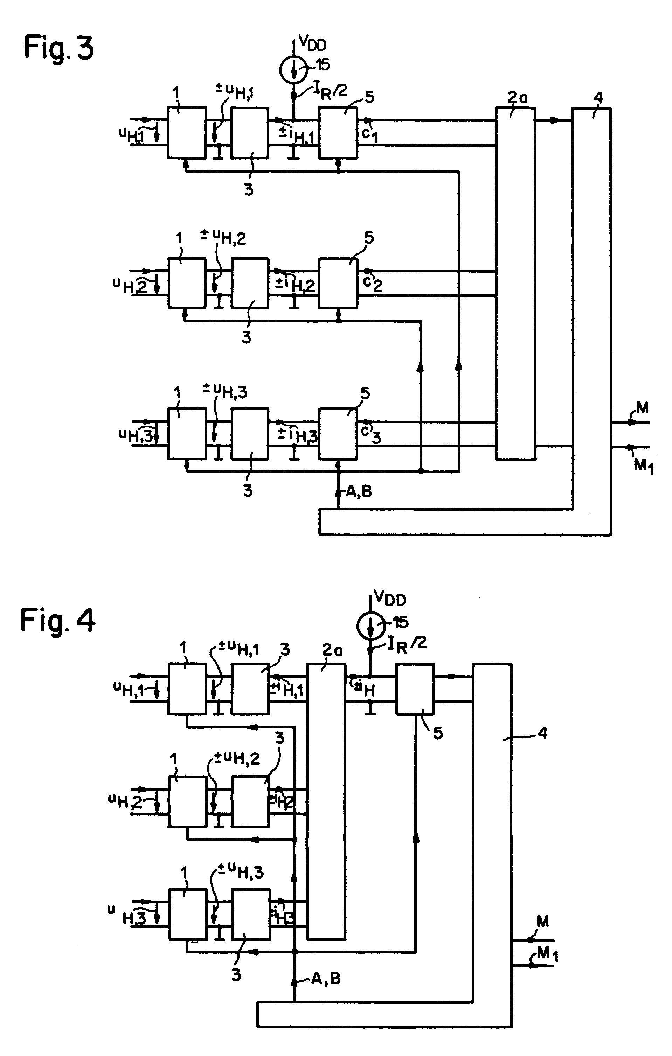

Drei Signale $u_{H,1}$, $u_{H,2}$ und $u_{H,3}$ speisen in allen drei in den Figuren 2 bis 4 dargestellten Varianten der erfindungsgemässen Anordnung einen Eingang je eines Polwenders 1. Es sind somit in allen drei Varianten je ein Polwender 1 pro Signal vorhanden. Ausserdem enthält jede Variante eine Summierschaltung 2, die einen zweipoligen Ausgang und soviel zweipolige oder einpolige Eingänge besitzt wie Signal vorhanden sind. In den Figuren 2 bis 4 sind somit drei zweipolige Eingänge der Summierschaltung 2 vorhanden. Alle in den Figuren 2 bis 4 dargestellten Bauelemente 1, 3, 4, 5 und 15 haben den gleichen Aufbau wie die gleich numerierten Bauelemente der Fig. 1. In allen drei Varianten ist ausserdem immer mindestens ein den ersten Polwendern 1 nachgeschalteter Spannungs/Strom-Wandler 3, mindestens ein dem Spannungs/Strom-Wandler 3 nachgeschalteter zweiter Polwender 5, eine Konstantstromquelle 15 und die Schaltung 4 vorhanden. In der Schaltung 4 ist immer eine Steuerschaltung 13; 14 bzw. 11; 12 enthalten zur Erzeugung mindestens eines periodischen Umschaltsignals A bzw. B für die Polwender 1 und 5. Jede Konstantstromquelle 15 dient der Erzeugung eines Referenzstromes $I_R/2$. Eine Konstantstromquelle 15 ist jeweils am Eingang des zweiten Polwenders 5 (Fig. 2, Fig. 4) bzw. eines der zweiten Polwender 5 (Fig. 3) angeordnet. Jeder zweite Polumschalter 5 ist vom gleichen Umschaltsignal A bzw. B gesteuert wie die ersten Polwender 1.

In der in der Fig. 2 dargestellten ersten Variante der Anordnung ist der Ausgang eines jeden ersten Polwenders 1 mit je einem der drei zweipoligen Eingänge der Summierschaltung 2 verbunden. Die Summierschaltung 2, ein Spannungs/Strom-Wandler 3 ein zweiter Polwender 5 und eine Schaltung 4 sind in der angegebenen Reihenfolge in einer Kettenschaltung 2;3;5;4 hintereinandergeschaltet. Ferner ist noch eine Konstantstromquelle 15 vorhanden, deren erster Pol mit einem nicht an Masse liegenden Ausgangspol des Spannungs/Strom-Wandlers 3 verbunden ist, während ihr zweiter Pol an der positiven Speisegleichspannung $V_{DD}$ liegt. Je ein Eingangspol des Spannungs/Strom-Wandlers 3 und des Polwenders 5 liegt an Masse. Die Steuereingänge der Polwender 1 und 5 sind alle miteinander verbunden und werden genau wie in der Fig. 1 von der Schaltung 4 mit einem Umschaltsignal A bzw. B gespeist.

Die in der Fig. 2 dargestellte Anordnung arbeitet ähnlich wie die in der Fig. 1 dargestellte Anordnung mit dem Unterschied, dass alle drei Signale $u_{H,1}$, $u_{H,2}$ und $u_{H,3}$ durch je einen Polwender 1 periodisch und synchron zueinander umgepolt werden und dass die so erhaltenen periodisch umgepolten Signale an den Ausgängen der Polwender 1 zuerst durch die Summierschaltung 2 miteinander addiert werden, bevor ihr Summensignal als Spannung $(+/-)u_H$ den Eingang des Spannungs/Strom-Wandlers 3 speist. Anschliessend wird dieses Summensignal in der Anordnung der Fig. 2 genauso aufbereitet und weiterbehandelt wie das Eingangssignal $(+/-)u_H$ desSpannungs/Strom-Wandlers 3 der in der Fig. 1 dargestellten Anordnung. Die Ausgangsfrequenz der Schaltung 4 ist dann in der ersten Variante proportional dem Summensignal. Die Bedingung $I_R/2>|(+/-)i_H + I_o|$ gilt auch für die in der Fig. 2 dargestellte Anordnung.

In der in der Fig. 3 dargestellten zweiten Variante der Anordnung sind pro erstem Polwender 1 und damit pro Signal je ein Spannungs/Strom-Wandler 3 und je ein zweiter Polwender 5 vorhanden. Die zueinandergehörigen ersten Polwender 1, Spannungs/Strom-Wandler 3 und zweiten Polwender 5 sind jeweils in der angegebenen Reihenfolge in einer Kettenschaltung 1;3;5 hintereinandergeschaltet. Der zweipolige Ausgang einer jeden dieser Kettenschaltungen 1; 3; 5 ist mit je einem der drei zweipoligen Eingänge einer Summierschaltung 2a verbunden. Die Summierschaltung 2a und eine Schaltung 4 sind in der angegebenen Reihenfolge in einer Kettenschaltung 2a;4 hintereinandergeschaltet. Ferner ist noch eine Konstantstromquelle 15 vorhanden, deren erster Pol mit einem nicht an Masse liegenden Ausgangspol eines der drei Spannungs/Strom-Wandler 3 verbunden ist, während ihr zweiter Pol an der positiven Speisegleichspannung $V_{DD}$ liegt. Je ein Eingangspol der Spannungs/Strom-Wandler 3 und der Polwender 5 liegt jeweils an Masse. Die Steuereingänge aller Polwender 1 und 5 sind miteinander verbunden und werden von der Schaltung 4 mit einem Umschaltsignal A, B gespeist.

Die in der Fig. 3 dargestellte Anordnung arbeitet ähnlich wie die in der Fig. 1 dargestellte Anordnung mit dem Unterschied, dass alle drei Signale $u_{H,1}$, $u_{H,2}$ und $u_{H,3}$ durch je eine Kettenschaltung 1; 3; 5 so behandelt werden wie das Eingangssignal $u_H$ der in der Fig. 1 dargestellten Anordnung durch die dortige Kettenschaltung 1; 3; 5 behandelt wird. Die Ausgangssignale $c_1$, $c_2$ und $c_3$ der Kettenschaltungen 1; 3; 5 werden in der Summierschaltung 2a miteinander addiert und das so erhaltene Summensignal speist anschliessend den Eingang der Schaltung 4. Dieses Summensignal wird in der Schaltung 4 der Fig. 2 genauso aufbereitet und weiterbehandelt wie das Eingangssignal der Schaltung 4 der in der Fig. 1 dargestellten Anordnung. Die Ausgangsfrequenz der Schaltung 4 ist dann in der zweiten Variante proportional dem Summensignal. Für die in der Fig. 3 dargestellte Anordnung gelten die Bedingungen:

$$IR>|c_1 + c_2 + c_3|$$
und
$$I_R/2>|(+/-)i_{H,1} + (+/-)i_{H,2} + (+/-)i_{H,3} + I_{o,1} + I_{o,2} + I_{o,3}|,$$

wobei $(+/-)i_{H,1}$, $(+/-)i_{H,2}$ und $(+/-)i_{H,3}$ die Nutzströme am Ausgang der drei Spannungs/Strom-Wandler 3 darstellen und $I_{o,1}$, $I_{o,2}$ und $I_{o,3}$ die drei Ausgangsströme der Spannungs/Strom-Wandler 3 darstellen, die proportional den drei Nullspannungen $U_{o,1}$, $U_{o,2}$ und $U_{o,3}$ dieser Spannungs/Strom-Wandler 3 sind.

In der in der Fig. 4 dargestellten dritten Variante der Anordnung ist pro erstem Polwender 1 und damit pro Signal je ein Spannungs/Strom-Wandler 3 vorhanden. Die zueinandergehörigen ersten Polwender 1 und Spannungs/Strom-Wandler 3 sind in der angegebenen Reihenfolge in einer Kettenschaltung 1;3 hintereinandergeschaltet. Der zweipolige Ausgang einer jeden dieser Kettenschaltungen 1; 3 ist mit je einem der drei zweipoligen Eingänge einer Summierschaltung 2a verbunden. Die Summierschaltung 2a, ein zweiter Polwender 5 und eine Schaltung 4 sind in der angegebenen Reihenfolge in einer Kettenschaltung 2a;5;4 hintereinandergeschaltet. Ferner ist noch eine Konstantstromquelle 15 vorhanden, deren erster Pol mit einem nicht an Masse liegenden Ausgangspol der Summierschaltung 2a verbunden ist, während ihr zweiter Pol an der positiven speisegleichspannung $V_{DD}$ liegt. Je ein Eingangspol der spannungs/Strom-Wandler 3 und des Polwenders 5 liegt an Masse. Die Steuereingänge der Polwender 1 und 5 sind alle miteinander verbunden und werden genau wie in der Fig. 1 von der Schaltung 4 mit einem Umschaltsignal A bzw. B gespeist.

Die in der Fig. 4 dargestellte Anordnung arbeitet ähnlich wie die in der Fig. 1 dargestellte Anordnung mit dem Unterschied, dass alle drei Signal $u_{H,1}$, $u_{H,2}$ und $u_{H,3}$ durch je eine Kettenschaltung 1; 3 so behandelt werden, wie das Eingangssignal $u_H$ in der in der Fig. 1 dargestellten Anordnung durch die dortige Kettenschaltung 1; 3 behandelt wird. Die Ausgangssignale der drei Kettenschaltungen 1; 3 speisen je einen der drei zweipoligen Eingänge der Summierschaltung 2a, in der sie addiert werden. Anschliessend wird dieses Summensignal $(+/-)i_H$ in der Anordnung der Fig. 4 genau so aufbereitet und weiterbehandelt wie das Ausgangssignal $(+/-)i_H$ des Spannungs/Strom-Wandlers 3 der in der Fig. 1 dargestellten Anordnung. Die Ausgangsfrequenz der Schaltung 4 ist dann in der dritten Variante proportional dem Summensignal. In der in der Fig. 4 dargestellten Anordnung gilt die Bedingung:

$$I_R/2 > |(+/-)i_{H,1} + (+/-)i_{H,2} + (+/-)i_{H,3} + I_{o,1} + I_{o,2} + I_{o,3}|.$$

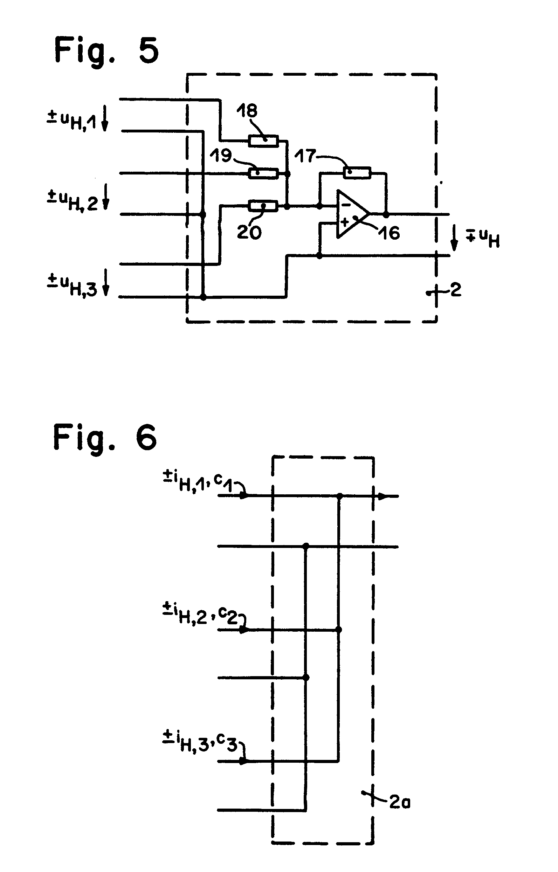

Die in der Fig. 5 dargestellte Summierschaltung 2 besteht aus einem Operationsverstärker 16, dessen Ausgang über einen Widerstand 17 auf einen invertierenden Eingang des Operationsverstärkers 16 und auf einen gemeinsamen Pol von drei sternförmig miteinander verbundenen Widerständen 18, 19 und 20 geführt ist. Der andere Pol der drei Widerstände 18 bis 20 bildet jeweils einen ersten Pol der drei Eingänge der Summierschaltung 2. Die zweiten Pole dieser Eingänge sind miteinander und mit einem nichtinvertierenden Eingang des Operationsverstärkers 16 sowie mit einem Pol des zweipoligen Ausgangs der Summierschaltung 2 verbunden. Der Ausgang des Operationsverstärkers 16 bildet seinerseits den zweiten Pol dieses Ausgangs.

Die in der Fig. 6 dargestellte Summierschaltung 2a enthält nur eine Verdrahtung, die darin besteht, dass alle ersten Pole der drei zweipoligen Eingänge der Summierschaltung 2a unter sich und mit einem ersten Pol des zweipoligen Ausgangs der Summierschaltung 2a verbunden sind. Desgleichen sind auch alle zweiten Pole dieser Eingänge und der zweite Pol dieses Ausganges miteinander verbunden.

## Patentansprüche

1. Anordnung zur Umwandlung einer Summe mehrerer, jeweils zu einem Einphasensignal eines Mehrphasensignals gehörender elektrischer Signale ($u_{H,1}$, $u_{H,2}$, $u_{H,3}$) in eine proportionale Frequenz, mit einer Summierschaltung (2), einem einpoligen Umschalter (9) zum Umschalten einer Referenzsignalquelle und einem Wandler, wobei die Summierschaltung (2) einen Eingang pro Signal ($u_{H,1}$, bzw. $u_{H,2}$, bzw. $u_{H,3}$) besitzt, der jeweils vom betreffenden Signal ($u_{H,1}$ bzw. $u_{H,2}$, bzw. $u_{H,3}$) gespeist ist, dadurch gekennzeichnet, dass der Wandler ein Spannungs/Strom-Wandler (3) und die Referenzsignalquelle eine erste Konstantstromquelle (10) ist, dass der pro Signal ($u_{H,1}$ bzw. $u_{H,2}$ bzw. $u_{H,3}$) vorhandene Eingang der Summierschaltung (2) jeweils vom betreffenden Signal ($u_{H,1}$ bzw. $u_{H,2}$ bzw. $u_{H,3}$) über einen pro Signal ($u_{H,1}$ bzw. $u_{H,2}$ bzw. $u_{H,3}$) vorhandenen ersten Polwender (1) gespeist ist, dass die Summierschaltung (2), der Spannungs/Strom-Wandler (3), ein zweiter Polwender (5) und eine Schaltung (4) in der angegebenen Reihenfolge in einer Kettenschaltung (2;3;5;4) hintereinandergeschaltet sind, dass innerhalb der Schaltung (4) deren, Eingang auf einen Kondensator (C) geführt ist, der mit der Summierschaltung (2) und dem Spannungs/Strom-Wandler (3) einen Integrator (2;3;C) bildet und dessen Kondensatorspannung ($u_c$) von einem Komparator (6) überwacht ist, dessen Ausgangssignal auf einen Steuereingang des einpoligen Umschalters (9) sowie auf einen Eingang eines eine Referenzfrequenz ($f_R/2$) von der Frequenz des Ausgangssignals des Komparators subtrahierenden Zählers (8) geführt ist, dass ein Pol der ersten Konstantstromquelle (10) über den einpoligen Umschalter (9) mit einem der Pole des Kondensators (C) verbunden ist, dass am Eingang des zweiten Polwenders (5) eine zweite Konstantstromquelle (15) angeordnet ist, deren Strom ($I_R/2$) dem Wert der Referenzfrequenz ($f_R/2$) entspricht und halb so gross ist wie der von der ersten Konstantstromquelle (10) gelieferte Referenzstrom ($I_R$), und dass Steuereingänge der ersten Polwender (1) und des zweiten Polwenders (5) mit dem gleichen, in einer Steuerschaltung (13;14 bzw. 11;12) erzeugten periodischen Umschaltsignal (A bzw. B) gespeist sind.

2. Anordnung zur Umwandung einer Summe mehrerer, jeweils zu einem Einphasensignal eines Mehrphasensignals gehörender elektrischer Signale ($u_{H,1}$, $u_{H,2}$, $u_{H,3}$) in eine proportionale Frequenz, mit einer Summierschaltung (2a), einem einpoligen Umschalter (9) zum Umschalten einer Referenzsignalquelle und mindestens einem Wandler, wobei die Summierschaltung (2a) einen Eingang pro Signal ($u_{H,1}$ bzw. $u_{H,2}$ bzw. $u_{H,3}$) besitzt, der jeweils vom betreffenden Signal ($u_{H,1}$ bzw. $U_{H,2}$ bzw. $u_{H,3}$) gespeist ist, dadurch gekennzeichnet, dass der Wandler ein Spannungs/Strom-Wandler (3) und pro Signal ($u_{H,1}$ bzw. $u_{H,2}$ bzw. $u_{H,3}$) vorhanden ist, dass die Referenzsignalquelle eine erste Konstantstromquelle (10) ist, dass der pro Signal ($u_{H,1}$ bzw. $u_{H,2}$ bzw. $u_{H,3}$) vorhandene Eingang der Summierschaltung (2a) jeweils vom betreffenden Signal ($u_{H,1}$ bzw. $u_{H,2}$ bzw. $u_{H,3}$) über eine Kettenschaltung (1;3;5) gespeist ist, in der ein pro Signal ($u_{H,1}$ bzw. $u_{H,2}$ bzw. $u_{H,3}$) vorhandener erster Polwender (1), der pro Signal ($u_{H,1}$ bzw. $u_{H,2}$ bzw. $u_{H,3}$) vorhandene Spannungs/Strom-Wandler (3) und ein pro Signal ($u_{H,1}$ bzw. $u_{H,2}$ bzw. $u_{H,3}$) vorhandener zweiter Polwender (5) in der angegebenen Reihenfolge hintereinandergeschaltet sind, dass die Summierschaltung (2a) und eine Schaltung (4) in der angegebenen Reihenfolge in einer Kettenschaltung (2a;4) hintereinandergeschaltet sind, dass innerhalb der Schaltung (4) deren Eingang auf einen Kondensator (C) geführt ist, der mit den Spannungs/Strom-Wandlern (3) und der Summierschaltung (2a) einen Integrator (2a;3;C) bildet und dessen Kondensatorspannung ($u_c$) von einem Komparator (6) überwacht ist, dessen Ausgangssignal auf einen Steuereingang des einpoligen Umschalters (9) sowie auf einen Eingang eines eine Referenzfrequenz ($f_R/2$) von der Frequenz des Ausgangssignals des Komparators subtrahierenden Zählers (8) geführt ist, dass ein Pol der ersten Konstantstromquelle (10) über den einpoligen Umschalter (9) mit einem der Pole des Kondensators (C) verbunden ist, dass am Eingang eines der zweiten Polwender (5) eine zweite Konstantstromquelle (15) angeordnet ist, deren Strom ($I_R/2$) dem Wert der Referenzfrequenz ($f_R/2$) entspricht und halb so gross ist wie der von der ersten Konstantstromquelle (10) gelieferte Referenzstrom ($I_R$), und dass Steuereingänge der ersten Polwender (1) und der zweiten Polwender (5) mit dem gleichen, in einer Steuerschaltung (13;14 bzw. 11;12) erzeugten periodischen Umschaltsignal (A bzw. B) gespeist sind.

3. Anordnung zur Umwandlung einer Summe mehrerer, jeweils zu einem Einphasensignal eines Mehrphasensignals gehörender elektrischer Signale ($u_{H,1}$, $u_{H,2}$, $u_{H,3}$) in eine proportionale Frequenz, mit einer Summierschaltung (2a), einem einpoligen Umschalter (9) zum Umschalten einer Referenzsignalquelle und mindestens einem Wandler, wobei die Summierschaltung (2a) einen Eingang pro Signal ($u_{H,1}$ bzw. $u_{H,2}$ bzw. $u_{H,3}$) besitzt, der jeweils vom betreffenden Signal ($u_{H,1}$, bzw. $u_{H,2}$ bzw. $u_{H,3}$) gespeist ist, dadurch gekennzeichnet, dass der Wandler ein Spannungs/Strom-Wandler (3) und pro Signal ($u_{H,1}$ bzw. $u_{H,2}$ bzw. $u_{H,3}$) vorhanden ist, dass die Referenzsignalquelle eine erste Konstantstromquelle (10) ist, dass der pro Signal ($u_{H,1}$ bzw. $u_{H,2}$ bzw. $u_{H,3}$) vorhandene Eingang der Summierschaltung (2a) vom betreffenden Signal ($u_{H,1}$ bzw. $u_{H,2}$ bzw. $u_{H,3}$) über eine Kettenschaltung (1;3) gespeist ist, in der ein pro Signal ($u_{H,1}$ bzw. $u_{H,2}$ bzw. $u_{H,3}$) vorhandener erster Polwender (1) und der pro Signal ($u_{H,1}$ bzw. $u_{H,2}$ bzw. $u_{H,3}$) vorhandene Spannungs/Strom-Wandler (3) in der angegebenen Reihenfolge hintereinandergeschaltet sind, dass die Summierschaltung (2a), ein zweiter Polwender (5) und eine Schaltung (4) in der angegebenen Reihenfolge in einer Kettenschaltung (2a;5;4) hintereinandergeschaltet sind, dass innerhalb der Schaltung (4) deren Eingang auf einen Kondensator (C) geführt ist, der mit den Spannungs/Strom-Wandlern (3) und der Summierschaltung (2a) einen Integrator (2a;3;C) bildet und dessen Kondensatorspannung ($u_c$) von einem Komparator (6) überwacht ist, dessen Ausgangssignal auf einen Steuereingang des einpoligen Umschalters (9) sowie auf einen Eingang eines eine Referenzfrequenz ($f_R/2$) von der Frequenz des Ausgangssignals des Komparators subtrahierenden Zählers (8) geführt ist, dass ein Pol der ersten Konstantstromquelle (10) über den einpoligen Umschalter (9) mit einem der Pole des Kondensators (c) verbunden ist, dass am Eingang des zweiten Polwenders (5) eine zweite Konstantstromquelle (15) angeordnet ist, deren Strom ($I_R/2$) dem Wert der Referenzfrequenz ($f_R/2$) entspricht und halb so gross ist wie der von der ersten Konstantstromquelle (10) gelieferte Referenzstrom ($I_R$), und dass Steuereingänge der ersten Polwender (1) und des zweiten Polwenders (5) mit dem gleichen, in einer Steuerschaltung (13;14 bzw. 11;12) erzeugten periodischen Umschaltsignal (A bzw. B) gespeist sind.

## Claims

1. An arrangement for converting a sum of a plurality of electrical signals ($u_{H,1}$, $u_{H,2}$, $u_{H,3}$) which each belong to a single-phase signal of a polyphase signal into a proportional frequency, comprising a summing circuit (2), a single-pole change-over switch (9) for switching over a reference signal source and a converter, wherein the summing circuit (2) has an input for each signal ($u_{H,1}$ and $u_{H,2}$ and $u_{H,3}$ respectively), each of which is fed by the respective signal ($u_{H,1}$ and $u_{H,2}$ and $u_{H,3}$ respectively), characterised in that the converter is a voltage/current converter (3) and the reference signal source is a first constant current source (10), that the input of the summing circuit (2), which is provided for each signal ($u_{H,1}$ and $u_{H,2}$ and $u_{H,3}$ respectively) is fed by the respective signal ($u_{H,1}$ and $u_{H,2}$ and $u_{H,3}$ respectively) by way of a first polarity inverter (1) which is provided for each signal ($u_{H,1}$ and $u_{H,2}$ and $u_{H,3}$ respectively), that the summing circuit (2), the voltage/current converter (3), a second polarity inverter (5) and a circuit (4) are connected in succession in the specified sequence in a cascade circuit (2; 3; 5; 4), that within the circuit (4) the input thereof is taken to a capacitor (C) which with the summing circuit (2) and the voltage/current converter (3) forms an integrator (2; 3; C) and the capacitor voltage ($u_C$) of which is monitored by a comparator (6) whose output signal is passed to a control input of the single-pole change-over switch (9) and to an input of a counter (8) which subtracts a reference frequency ($f_R/2$) from the frequency of the output signal of the comparator (6), that a pole of the first constant current source (10) is connected to one of the poles of the capacitor (C) by way of the single-pole change-over switch (9), that arranged at the input of the second polarity inverter (5) is a second constant current source (15) whose current ($I_R/2$) corresponds to the value of the reference frequency ($f_R/2$) and is half as great as the reference current ($I_R$) supplied by the first constant current source (10) and that control inputs of the first polarity inverters (1) and the second polarity inverter (5) are fed with the same periodic switching-over signal (A or B respectively) which is produced in a control circuit (13; 14 or 11; 12 respectively).

2. An arrangement for converting a sum of a plurality of electrical signals ($u_{H,1}$, $u_{H,2}$, $u_{H,3}$) which each belong to a single-phase signal of a polyphase signal into a proportional frequency, comprising a summing circuit (2a), a single-pole change-over switch (9) for switching over a reference signal source and at least one converter, wherein the summing circuit (2a) has an input for each signal ($u_{H,1}$ and $u_{H,2}$ and $u_{H,3}$ respectively), each of which is fed by the respective signal ($u_{H,1}$ and $u_{H,2}$ and $u_{h,3}$ respectively), characterised in that the converter is a voltage/current converter (3) and is provided for each signal ($u_{H,1}$ and $u_{H,2}$ and $u_{H,3}$ respectively), that the reference signal source is a constant current source (10), that the input, which is provided for each signal ($u_{H,1}$ and $u_{H,2}$ and $u_{H,3}$ respectively), of the summing circuit (2a) is fed by the respective signal ($u_{H,1}$ and $u_{H,2}$ and $u_{H,3}$ respectively) by way of a cascade circuit (1; 3; 5) in which a first polarity inverter (1) which is provided for each signal ($u_{H,1}$ and $u_{H,2}$ and $u_{H,3}$ respectively), the voltage/current converter (3) provided for each signal ($u_{H,1}$ and $u_{H,2}$ and $u_{H,3}$ respectively) and a second polarity inverter (5) provided for each signal ($u_{H,1}$ and $u_{H,2}$ and $u_{H,3}$ respectively) are connected in succession in the specified sequence, that the summing circuit (2a) and a circuit (4) are connected in succession in the specified sequence in a cascade circuit (2a; 4), that within the circuit (4) the input thereof is taken to a capacitor (C) which with the voltage/current converters (3) and the summing circuit (2a) forms an integrator (2a; 3; C) and whose capacitor voltage ($u_C$) is monitored by a comparator (6) whose output signal is taken to a control input of the single-pole change-over switch (9) and to an input of a counter (8) which subtracts a reference frequency ($f_R/2$) from the frequency of the output signal of the comparator (6), that a pole of the first constant current source (10) is connected by way of the single-pole change-over switch (9) to one of the poles of the capacitor (C), that arranged at the input of one of the second polarity inverters (5) is a second constant current source (15) whose current ($I_R/2$) corresponds to the value of the reference frequency ($f_R/2$) and is half as great as the reference current ($I_R$) supplied by the first constant current source (10) and that control inputs of the first polarity inverters (1) and the second polarity inverters (5) are fed with the same periodic switching-over signal (A or B respectively) which is produced in a control circuit (13; 14 or 11; 12 respectively).

3. An arrangement for converting a sum of a plurality of electrical signals ($u_{H,1}$, $u_{H,2}$, $u_{H,3}$) which each belong to a single-phase signal of a polyphase signal into a proportional frequency, comprising a summing circuit (2a), a single-pole change-over switch (9) for switching over a reference signal source and at least one converter, wherein the summing circuit (2a) has an input for each signal ($u_{H,1}$ and $u_{H,2}$ and $u_{H,3}$ respectively), each of which is fed by the respective signal ($u_{H,1}$ and $u_{H,2}$ and $u_{H,3}$ respectively), characterised in that the converter is a voltage/current converter (3) and is provided for each signal ($u_{H,1}$ and $u_{H,2}$ and $u_{H,3}$ respectively), that the reference signal source is a first constant current source (10), that the input, which is provided for each signal ($u_{H,1}$ and $u_{H,2}$ and $u_{H,3}$ respectively), of the summing circuit (2a) is fed by the respective signal ($u_{H,1}$ and $u_{H,2}$ and $u_{H,3}$ respectively) by way of a cascade circuit (1; 3) in which a first polarity inverter (1) which is provided for each signal ($u_{H,1}$ and $u_{H,2}$ and $u_{H,3}$ respectively) and the voltage/current converter (3) which is provided for each signal ($u_{H,1}$ and $u_{H,2}$ and $u_{H,3}$ respectively) are connected in succession in the specified sequence, that the summing circuit (2a), a second polarity inverter (5) and a circuit (4) are connected in succession in the specified sequence in a cascade circuit (2a; 5; 4), that within the circuit (4) the input thereof is taken to a capacitor (C) which with the voltage/current converters (3) and the summing circuit (2a) forms an integrator (2a; 3; C) and whose capacitor voltage ($u_c$) is monitored by a comparator (6) whose output signal is taken to a control input of the single-pole change-over switch (9) and to an input of a counter (8) which subtracts a reference frequency ($f_R/2$) from the frequency of the output signal of the comparator (6), that a pole of the first constant current source (10) is connected by way of the single-pole change-over switch (9) to one of the poles of the capacitor (C), that arranged at the input of the second polarity inverter (5) is a second constant current source (15) whose current ($I_R/2$) corresponds to the value of the reference frequency ($f_R/2$) and is half as great as the reference current ($I_R$) supplied by the first constant current source (10) and that control inputs of the first polarity inverters (1) and the second polarity inverter (5) are fed with the same periodic switching-over signal (A or B respectively) which is produced in a control circuit (13; 14 or 11; 12 respectively).

## Revendications

1. Dispositif pour convertir une somme de plusieurs signaux électriques correspondant chacun à un signal monophasé d'un signal polyphasé ($u_{H,1}$, $u_{H,2}$, $u_{H,3}$) en une fréquence proportionnelle, dispositif comportant un circuit de sommation (2), un commutateur unipolaire (9) pour la commutation d'une source de signaux de référence et un convertisseur, le circuit de sommation (2) comportant par signal ($u_{H,1}$, $u_{H,2}$, $u_{H,3}$) une entrée qui est respectivement alimentée par le signal correspondant ($u_{H,1}$, $u_{H,2}$, $u_{H,3}$), dispositif caractérisé en ce que le convertisseur est un convertisseur tension/courant (3) et la source de signaux de référence est une première source de courant constant (10), en ce que l'entrée, prévue pour chaque signal ($u_{H,1}$, $u_{H,2}$, $u_{H,3}$), du circuit de sommation reçoit à chaque fois un signal correspondant ($u_{H,1}$, $u_{H,2}$, $u_{H,3}$) par l'intermédiaire d'un premier inverseur polaire (1) prévu pour chaque signal ($u_{H,1}$, $u_{H,2}$, $u_{H,3}$), en ce que le circuit de sommation (2), le convertisseur tension/courant (3), un second inverseur polaire (5) et un circuit (4) sont connectés en série dans la séquence indiquée sous la forme d'un circuit en chaîne (2 ; 3 ; 5 ; 4), en ce que, dans le circuit (4) son entrée est reliée à un condensateur (C), qui constitue avec le circuit de sommation (2) et avec le convertisseur tension/courant (3) un intégrateur (2 ; 3 ; C) et dont la tension de condensateur ($u_c$) est contrôlée par un comparateur (6), dont le signal de sortie est appliqué à une entrée de commande du commutateur unipolaire (9) ainsi qu'à une entrée d'un compteur (8) soustrayant la fréquence de référence ($f_R/2$) de la fréquence du signal de sortie du comparateur, en ce qu un pôle de la première source de courant constant (10) est relié, par l'intermédiaire du commutateur unipolaire (9), avec un des pôles du condensateur (C), en ce qu'une entrée du second inverseur polaire (5) est reliée à une seconde source de courant constant (15), dont le courant correspond à la valeur de la fréquence de référence ($f_R/2$) et a la moitié de la grandeur du courant de référence ($I_R$) fourni par la première source de courant constant (10), et en ce que des entrées de commande du premier inverseur polaire (1) et du second inverseur polaire (5) reçoivent le même signal périodique de commutation (A ou B).

2. Dispositif pour la conversion d'une somme de plusieurs signaux électriques ($u_{H,1}$, $u_{H,2}$, $u_{H,3}$), produits dans un circuit de commande (13 ; 14 ou 11 ; 12) et correspondant chacun à un signal monophasé d'un signal polyphasé, en une fréquence proportionnelle, dispositif comportant un circuit de sommation (2a), un commutateur unipolaire (9) pour la commutation d'une source de signaux de référence et au moins un convertisseur, le circuit de sommation (2a) comportant pour chaque signal ($u_{H,1}$, $u_{H,2}$, $u_{H,3}$) une entrée qui est alimentée respectivement par le signal correspondant ($u_{H,1}$, $u_{H,2}$, $u_{H,3}$), dispositif caractérisé en ce que le convertisseur est un convertisseur tension/courant (3) et est prévu pour chaque signal ($u_{H,1}$, $u_{H,2}$, $u_{H,3}$), en ce que la source de signaux de référence est une première source de courant constant (10), en ce que l'entrée, prévue pour chaque signal ($u_{H,1}$, $u_{H,2}$, $u_{H,3}$), du circuit de sommation (2a) reçoit respectivement le signal correspondant ($u_{H,1}$, $u_{H,2}$, $u_{H,3}$) par l'intermédiaire d'un circuit en chaîne (1 ; 3 ; 5), dans lequel un premier inverseur polaire (1) prévu pour chaque signal ($u_{H,1}$, $u_{H,2}$, $u_{H,3}$), le convertisseur tension/courant (3), prévu pour chaque signal ($u_{H,1}$, $u_{H,2}$, $u_{H,3}$) et un second inverseur polaire (5), prévu pour chaque signal ($u_{H,1}$, $u_{H,2}$, $u_{H,3}$) sont reliés en série dans la séquence indiquée, en ce que le circuit de sommation (2a) et un circuit (4) sont reliés en série dans la séquence indiquée sous la forme d'un circuit en chaîne (2a ; 4), en ce que, dans le circuit (4), son entrée est reliée à un condensateur (C) qui forme avec le convertisseur tension/courant (3) et le circuit de sommation (2a), un intégrateur (2a ; 3 ; C) et dont la tension de condensateur ($u_c$) est contrôlée par un comparateur (6), dont le signal de sortie est appliqué à une entrée de commande du commutateur unipolaire (9) ainsi qu'à une entrée d'un compteur (8) soustrayant la fréquence de référence ($f_R/2$) de la fréquence du signal de sortie du comparateur (6), en ce qu'un pôle de la première source de courant constant (10) est relié, par l'intermédiaire du commutateur unipolaire (9), avec un des pôles du condensateur (C), en ce qu'une entrée du second inverseur polaire (5) est reliée à une seconde source de courant constant (15) dont le courant ($I_R/2$) correspond à la valeur de la fréquence de référence ($f_R/2$) et a la moitié de la grandeur du courant de référence ($I_R$) fourni par la première source de courant constant (10), et en ce que des entrées de commande du premier inverseur polaire (1) et du second inverseur polaire (5) reçoivent le même signal périodique de commutation (A ou B).

**3.** Dispositif pour la conversion d'une somme de plusieurs signaux électriques ($u_{H,1}$, $u_{H,2}$, $u_{H,3}$), produits dans un circuit de commande (13 ; 14 ou 11 ; 12) et correspondant chacun à un signal monophasé d'un signal polyphasé, en une fréquence proportionnelle, dispositif comportant un circuit de sommation (2a), un commutateur unipolaire (9) pour la commutation d'une source de signaux de référence et au moins un convertisseur, le circuit de sommation (2a) comportant une entrée par signal ($u_{H,1}$, $u_{H,2}$, $u_{H,3}$), qui reçoit respectivement le signal correspondant ($u_{H,1}$, $u_{H,2}$, $u_{H,3}$), dispositif caractérisé en ce que le convertisseur est un convertisseur tension/courant (3) et est prévu pour chaque signal ($u_{H,1}$, $u_{H,2}$, $u_{H,3}$), en ce que la source de signaux de référence est une première source de courant constant (10), en ce que l'entrée, prévue pour chaque signal ($u_{H,1}$, $u_{H,2}$, $u_{H,3}$), du circuit de sommation (2a) reçoit le signal correspondant ($u_{H,1}$, $u_{H,2}$, $u_{H,3}$) par l'intermédiaire d'un circuit en chaîne (1 ; 3), dans lequel un premier inverseur polaire (1), prévu pour chaque signal ($u_{H,1}$, $u_{H,2}$, $u_{H,3}$), et le convertisseur tension/courant (3), prévu pour chaque signal ($u_{H,1}$, $u_{H,2}$, $u_{H,3}$) sont reliés en série dans la séquence indiquée, en ce que le circuit de sommation (2a), un second inverseur polaire (5) et un circuit (4) sont reliés entre eux dans la séquence indiquée sous la forme d'un circuit en chaîne (2a ; 5 ; 4), en ce que dans le circuit (4) son entrée est reliée à un condensateur (C), qui forme avec les convertisseurs tension/courant (3) et le circuit de sommation (2a) un intégrateur (2a ; 3 ; C) et dont la tension de condensateur ($u_c$) est contrôlée par un comparateur (6), dont le signal de sortie est appliqué à une entrée de commande du commutateur unipolaire (9) ainsi qu'à une entrée d'un compteur (8) soustrayant la fréquence de référence ($f_R/2$) de la fréquence du signal de sortie du comparateur, en ce qu'un pôle de la première source de courant constant (10) est relié par l'intermédiaire du commutateur unipolaire (9) avec un des pôles du condensateur (C), en ce qu'une entrée du second inverseur polaire (5) est reliée à une seconde source de courant constant (15), dont le courant ($I_R/2$) correspond à la valeur de la fréquence de référence ($f_R/2$) et a la moitié de la grandeur du courant de référence ($I_R$) fourni par la première source de courant constant (10), et en ce que des entrées de commande du premier inverseur polaire (1) et du second inverseur polaire (5) reçoivent le même signal périodique de commutation (A ou B) produit dans un circuit de commande (13 ; 14 ou 11 ; 12).

# Fig. 1

# Fig. 2

Fig. 3

Fig. 4

# Fig. 5

# Fig. 6